# EUROPÄISCHE PATENTSCHRIFT

(11) **EP 1 525 625 B1**
(45) Veröffentlichungstag und Bekanntmachung des Hinweises auf die Patenterteilung: **30.07.2014**
(21) Anmeldenummer: 03787607.5
(22) Anmeldetag: 20.06.2003
(51) Int. Cl.: H01L 33/00

(54) **STRAHLUNGSEMITTIERENDES DÜNNSCHICHT-HALBLEITERBAUELEMENT AUF GAN-BASIS**
GAN-BASED RADIATION-EMITTING THIN-LAYERED SEMICONDUCTOR COMPONENT
COMPOSANT A SEMICONDUCTEUR EN COUCHE MINCE EMETTEUR DE RAYONNEMENT A BASE DE GAN

(30) Priorität: 31.07.2002 DE 10234977
(43) Veröffentlichungstag der Anmeldung: 27.04.2005
(73) Patentinhaber: OSRAM Opto Semiconductors GmbH, 93055 Regensburg (DE)
(72) Erfinder: EISERT, Dominik, 93049 Regensburg (DE); HAHN, Berthold, 93155 Hemau (DE); HÄRLE, Volker, 93164 Laaber (DE)
(74) Vertreter: Epping - Hermann - Fischer
(86) Internationale Anmeldenummer: PCT/DE2003/002071
(87) Internationale Veröffentlichungsnummer: WO 2004/017430

(56) Entgegenhaltungen:
- WO-A-01/41225
- US-A- 6 091 085
- US-B1- 6 258 618
- US-B1- 6 346 771
- US-B1- 6 410 942

## Beschreibung

Die vorliegende Erfindung betrifft strahlungsemittierende Dünnschicht-Halbleiterbauelemente auf GaN-Basis nach dem Oberbegriff des unabhängigen Patentanspruchs.

Herkömmliche strahlungsemittierende Halbleiterbauelemente haben aus fertigungstechnischen Gründen häufig eine rechtwinklige Geometrie. Die Halbleiterbauelemente bestehen im allgemeinen aus einer epitaktisch auf einem Trägersubstrat abgeschiedenen Mehrschichtstruktur mit einer aktiven, strahlungserzeugenden Schicht. Das Trägersubstrat ist vorzugsweise elektrisch leitfähig, um einen vertikalen Stromfluss zu ermöglichen; außerdem ist es in vielen Fällen günstig, wenn das Trägersubstrat für die in der aktiven Schicht der Mehrschichtstruktur erzeugte Strahlung transparent ist. Allerdings steht eine hohe Transparenz häufig in Widerspruch zu einer hohen elektrischen Leitfähigkeit des Materials für das Trägersubstrat. So ist zum Beispiel der für Leuchtdioden auf GaN-Basis verwendete Saphir für blaues Licht transparent, aber nicht elektrisch leitfähig. Siliziumcarbid als Trägersubstrat für GaN-Leuchtdioden ist dagegen zwar leitfähig und transparent, aber die Transparenz nimmt mit zunehmender Leitfähigkeit ab, so dass die Eigenschaften des Halbleiterbauelements auch in diesem Fall nicht ideal sind.

Eine Möglichkeit zur Verringerung der Absorptionsverluste und damit zur Steigerung des externen Wirkungsgrades ist daher das Entfernen des Trägersubstrats in Verbindung mit geeigneten Spiegelschichten (Dünnfilmkonzept). Allerdings ist ein Halbleiterdünnfilm im wesentlichen eine planparallele Platte, deren Auskoppeleffizienz aufgrund der Geometrie gegenüber einer Standarddiode nicht erhöht ist. Insbesondere wenn für das Halbleiterbauelement bereits ein nur wenig absorbierendes Trägersubstrat (zum Beispiel GaN auf SiC) verwendet wurde, ist die Steigerung des externen Wirk-ungsgrades des Dünnschicht-Halbleiterbauelements zu gering, um den erhöhten technischen Aufwand der Entfernung des Trägersubstrats zu rechtfertigen.

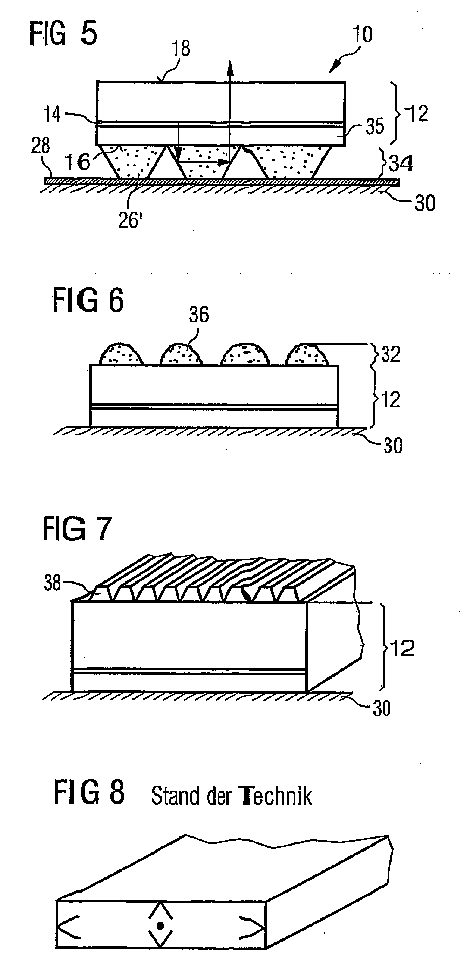

Zur Erläuterung der Problematik der Strahlungsauskopplung zeigt Figur 8 schematisch ein Halbleiterbauelement mit den Kegeln der Strahlungs auskopplung. Strahlung kann aus dem Halbleiterbauelement nur aus einem Kegel mit einem Öffnungs-winkel von θ = sin⁻¹(nₑₓₜ/nᵢₙₜ) ausgekoppelt werden, wobei nᵢₙₜ den Brechungsindex des Halbleitermaterials und nₑₓₜ den Brechungsindex der Umgebung bezeichnet. Für einen GaN-Halbleiter (nᵢₙₜ = 2,5) beträgt des Auskoppelwinkel θ gegen Luft (nₑₓₜ = 1) 23° und gegen einen Kunststoffverguss (nₑₓₜ = 1, 5) 37°. Im Halbleiterbauelement erzeugte Strahlung, die nicht innerhalb eines Kegels auf die Grenzflächen trifft, wird schließlich reabsorbiert und in Wärme umgewandelt. Der Auskoppelkegel ist für GaN-Systeme im Vergleich zu GaAs-Systemen (nᵢₙₜ = 3,5) zwar groß, führt aber dennoch zu unerwünscht großen Strahlungsverlusten.

Diese Verhältnisse ändern sich auch nicht wesentlich bei veränderten Schichtdicken. Allerdings ist für den über die oberseite ausgekoppelten Strahl die Dünnfilmgeometrie günstig, da aufgrund des kurzen Weges im Halbleiter die Absorption gering ist; für den seitlich ausgekoppelten. Strahl kann dagegen die Effizienz aufgrund der Mehrfachreflexionen im Halbleiter sogar geringer sein.

Es gibt deshalb bereits verschiedene Ansätze, den extrernen Wirkungsgrad von Halbleiterbauelementen durch veränderte Geometrien zu erhöhen. Hier ist insbesondere eine sogenannte Mikros-trukturierung der gesamten Mehrschichtstruktur zu nennen, die aufgrund der größeren Gesamtfläche der Seitenflächen der Mehr schichtstruktur zu einer verstärkten seitlichen Strahlungsauskopplung führt. Zusätzlich können die Seitenflächen der so erzeugten einzelnen Mehrschichtstrukturen angeschrägt werden. Beispiele für derartige Halbleiterbauelemente sind in DE-A-198 07 758, EP-A-0 905 797 oder JP-A-08-288543 offenbart.

Eine weitere Möglichkeit zur Erhöhung der Strahlungsauskopplung ist in den Figuren 3 und 5 der DE-A-199 11 717 gezeigt. Hier sind der Mehrschichtstruktur mit der aktiven, strahlungserzeugenden Schicht einzelne Strahlungsauskoppelelemente in Form von Kugelsegmenten oder Kegelstümpfen zugeordnet, die beispielsweise mittels entsprechendem Ätzen von aufgewachsenen Schichten ausgebildet werden.

Alle genannten Druckschriften zum Stand der Technik befassen sich jedoch nicht mit Dünnschicht-Halbleiterbauelementen auf GaN-Basis. Halbleiterbauelemente auf GaN-Basis dienen vorwiegend der Strahlungserzeugung im blau-grünen Spektralbereich und weisen eine Mehrzahl von Schichten auf, die aus einem GaN-basierenden Material bestehen. Unter einem GaN-basierenden Material werden im Rahmen dieser Erfindung neben GaN selbst auch von GaN abgeleitete oder mit GaN verwandte Materialien sowie darauf aufbauende ternäre oder quaternäre Mischkristalle verstanden. Insbesondere zählen hierzu die Materialien GaN, AlM, InN, Al₁₋ₓGaₓN, In₁₋ₓGaₓN, In₁₋ₓAlₓN und Al_{1x-y}InₓGa_{y}N mit 0 < x < 1, 0 < y < 1 und x + y ≤ 1.

Die Druckschrift US 6,258,618 B1 offenbart eine LED mit einem Kontakt vom p-Typ, der aus einem hochreflektiven Material mit nahe benachbarten Öffnungen gefertigt ist, welche die Lichtextraktionseffizienz erhöhen.

Die Druckschrift US 6,346,771 B1 offenbart eine Hochleistungs-LED-Lampe mit einem LED-Chip, der dreieckige lichtemittierende Elemente aufweisen kann, welche die Lichtextraktion vom Halbleiter verbessern.

Die Druckschrift WO 01/41225 A2 offenbart LEDs mit Lichtextraktionsstrukturen auf oder in der LED, welche die Effizienz verbessern.

In der Figur 6 dieses Dokuments wird ein strahlungsemittierendes Dünnschicht-Halbleiterbauelement mit einer Mehrschichtstruktur auf GaN-Basis gezeigt, wobei die Mehrschichtstruktur eine aktive, strahlungserzeugende Schicht enthält und eine erste Hauptfläche und eine der ersten Hauptfläche abgewandte zweite Hauptfläche zum Auskoppeln der in der aktiven, strahlungserzeugenden Schicht erzeugten Strahlung aufweist, wobei die erste Hauptfläche der Mehrschichtstruktur mit einer reflektierenden Grenzfläche (die Oberfläche des Substrats) gekoppelt ist, und zwischen der ersten Hauptfläche der Mehrschichtstruktur und der reflektierenden Grenzfläche eine transparente Schicht vorgesehen ist, und wobei die transparente Schicht zwischen der ersten Hauptfläche der Mehrschichtstruktur und der reflektierenden Grenzfläche konvexe Erhebungen als Lichtextraktionsstrukturen aufweist.

Das strahlungsemittierende Dünnschicht-Halbleiterbauelement gemäß einer Abwandlung weist eine Mehrschichtstruktur auf GaN-Basis auf, die eine aktive, strahlungserzeugende Schicht enthält und eine erste Hauptfläche und eine der ersten Hauptfläche abgewandte zweite Hauptfläche zum Auskoppeln der in der aktiven, strahlungserzeigenden Schicht erzeugten Strahlung aufweist. Weiterhin ist die erste Hauptfläche der Mehrschichtstruktur mit einer reflektierenden Schicht bzw. Grenzfläche gekoppelt, und der an die zweite Hauptfläche der Mehrschichtstruktur angrenzende Bereich der Mehrschichtstruktur ist ein- oder zweidimensional strukturiert.

Die Erhöhung des externen Wirkungsgrades der Strahlungsauskopplung beruht auf der Brechung der rechtwinkligen Geometrie des Dünnschicht-Halbleiterbauelements durch eine Strukturierung des Halbleiterdünnfilms selbst. Die Steigerung des Wirkungsgrades wird im Rahmen der nachfolgenden detaillierten Beschreibung mit Hilfe von Simulationen belegt.

Der an die zweite Hauptfläche der Mehrschichtstruktur angrenzende Bereich der Mehrschichtstruktur weist konvexe Erhebungen, vorzugsweise in Form von Pyramidenstümpfen, Kegelstümpfen, Kegeln oder Kugelsegmenten (zweidimensionale Strukturierung) bzw. mit einer trapezoiden, dreieckigen oder Kreissegment-Querschnittsform (eindimensionale Strukturierung) auf.

Es liegt der Öffnungswinkel der Erhebungen zwischen etwa 30° und etwa 70°, besonders bevorzugt zwischen etwa 40° und etwa 50°. Außerdem ist die Höhe der Erhebungen wenigstens so groß, vorzugsweise etwa doppelt so groß wie die Höhe eines planen Bereichs der Mehrschichtstruktur zwischen der aktiven, strahlungserzeugenden Schicht und den Erhebungen ist. Das Rastermaß der Erhebungen wird höchstens etwa fünfmal, vorzugsweise höchstens etwa dreimal so groß wie die Höhe der Erhebungen gewählt.

Die mit der ersten Hauptfläche der Mehrschichtstruktur gekoppelte Schicht bzw. Grenzfläche weist vorteilhafterweise einen Reflexionsgrad von mindestens 70%, besser von mindestens 85% auf.

Die Mehrschichtstruktur kann entweder mit ihrer ersten Hauptfläche direkt oder über eine reflektierende Schicht auf einem Trägersubstrat aufgebracht sein, wobei die reflektierende Schicht bzw. das Trägersubstrat zugleich als Kontaktfläche des Halbleiterbauelements dient.

Als Ausgleich einer begrenzten Querleitfähigkeit der dünnen Halbleiterschicht kann auf der zweiten Hauptfläche der Mehrschichtstruktur eine leitfähige, transparente Schicht aufgebracht sein.

Zum Schutz gegen externe Einflüsse kann auf der zweiten Hauptfläche der Mehrschichtstruktur eine transparente Schutz- bzw. Vergütungsschicht aufgebracht sein.

Der vorliegenden Erfindung liegt die Aufgabe zugrunde, ein strahlungsemittierendes Dünnschicht-Halbleiterbauelement auf GaN-Basis bereitzustellen, das einen verbesserten externen Wirkungsgrad der Strahlungsauskopplung aufweist.

Gemäß der vorliegenden Erfindung wird diese Aufgabe durch ein Halbleiterbauelement mit den Merkmalen von Patentanspruch 1 gelöst. Vorteilhafte Ausgestaltungen und Weiterbildungen dieses Halbleiterbauelements sind in den abhängigen Ansprüchen 2 bis 11 definiert.

Dieses strahlungsemittierende Dünnschicht-Halbleiterbauelement gemäß der Erfindung weist eine Mehrschichtstruktur auf GaN-Basis auf, die eine aktive, strahlungserzeugende Schicht enthält und eine erste Hauptfläche und eine der ersten Hauptfläche abgewandte zweite Hauptfläche zum Auskoppeln der in der aktiven, strahlungserzeugenden Schicht erzeugten Strahlung aufweist. Die erste Hauptfläche der Mehrschichtstruktur ist wiederum mit einer reflektierenden Schicht gekoppelt. Im Gegensatz zu dem oben beschriebenen Halbleiterbauelement ist hier zwischen der ersten Hauptfläche der Mehrschichtstruktur und der reflektierenden Schicht eine transparente Schicht vorgesehen, welche ein- oder zweidimensional strukturiert ist.

Die Strukturierung dieser transparenten Schicht zwischen der Mehrschichtstruktur und der reflektierenden Schicht bzw. Grenzfläche hat die gleiche Wirkung wie die Strukturierung der Mehrschichtstruktur selbst und erhöht in gleicher Weise den externen Wirkungsgrad der Strahlungsauskopplung.

Vorzugsweise ist die transparente Schicht leitfähig, um die begrenzte Querleitfähigkeit einer dünnen Mehrschichtstruktur auszugleichen.

Die transparente Schicht zwischen der ersten Hauptfläche der Mehrschichtstruktur und der reflektierenden Schicht bzw. Grenzfläche weist konvexe Erhebungen vorzugsweise in Form von Pyramidenstümpfen oder Kegelstümpfen (zweidimensionale Strukturierung) bzw. eine trapezoide Querschnittsform (eindimensionale Strukturierung) auf.

In einer bevorzugten Ausführungsform weisen diese Erhebungen einen Öffnungswinkel zwischen etwa 30° und etwa 70°, bevorzugt zwischen etwa 40° und etwa 50° auf. Dabei ist die Höhe der Erhebungen wenigstens so groß, vorzugsweise etwa doppelt so groß wie die Höhe eines planen Bereichs der Mehrschichtstruktur zwischen der aktiven, strahlungserzeugenden Schicht und den Erhebungen gewählt, und das Rastermaß der Erhebungen beträgt höchstens das Fünffache, vorzugsweise höchstens das Dreifache der Höhe der Erhebungen.

Die mit der ersten Hauptfläche der Mehrschichtstruktur gekoppelte Schicht weist einen Reflexionsgrad von wenigstens 85% auf.

Die reflektierende Schicht kann auf einem Trägersubstrat aufgebracht sein oder die reflektierende Grenzfläche ist durch ein Trägersubstrat gebildet, wobei die reflektierende Schicht bzw. das Trägersubstrat zugleich als Kontaktfläche des Halbleiterbauelements dient.

Die obigen sowie weitere Merkmale und Vorteile der vorliegenden Erfindung werden anhand der folgenden detaillierten Beschreibung unter Bezugnahme auf die beiliegenden Zeichnungen näher beschrieben. Darin zeigen:
- Figur 1: eine schematische Darstellung einer ersten Abwandlung eines Halbleiterbauelements im Schnitt;
- Figuren 2a) bis c): schematische Darstellungen zur Erläuterung des optimalen Öffnungswinkels der Erhebungen des Halbleiterbauelements von Figur 1;
- Figuren 3a) bis e): Ergebnisse verschiedener Simulationen zur Erläuterung verschiedener optimaler Parameter der Erhebungen des Halbleiterbauelements von Figur 1;
- Figur 4: eine schematische Darstellung einer Abwandlung des Halbleiterbauelements von Figur 1;
- Figur 5: eine schematische Darstellung eines Ausführungsbeispiels eines Halbleiterbauelements gemäß der vorliegenden Erfindung im Schnitt;
- Figur 6: eine schematische Darstellung einer weiteren Abwandlung des Halbleiterbauelements von Figur 1;
- Figur 7: eine schematische Darstellung einer noch weiteren Abwandlung des Halbleiterbauelements von Figur 1; und
- Figur 8: eine stark schematisierte Darstellung bezüglich der Strahlungsauskopplung herkömmlicher Halbleiterbauelemente.

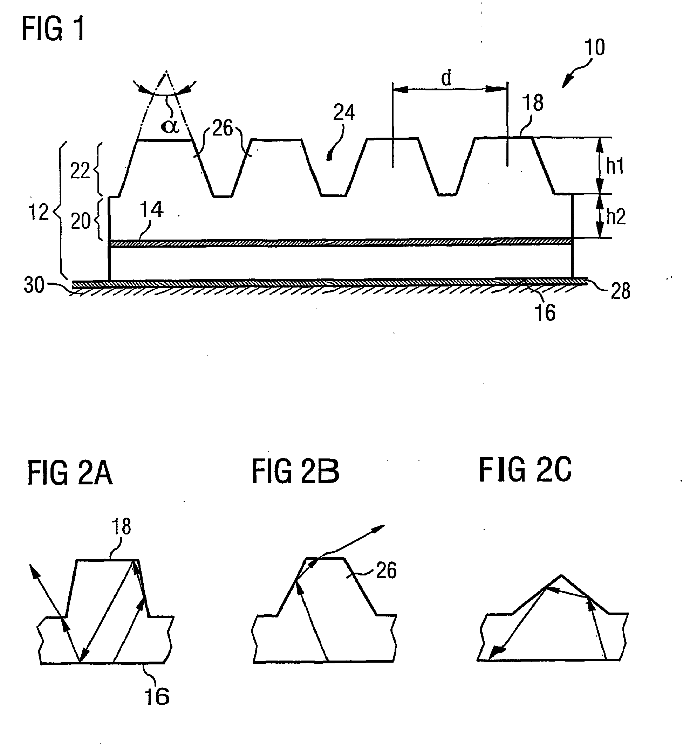

In Figur 1 ist eine erste Abwandlung eines Dünnschicht-Halbleiterbauelements dargestellt. Ein Hauptbestandteil des Halbleiterbauelements 10 ist eine Mehrschichtstruktur 12 auf GaN-Basis, die eine aktive, strahlungserzeugende Schicht 14 enthält. Die Mehrschichtstruktur 12 ist in üblicher Weise epitaktisch gewachsen und enthält bekanntermaßen eine Mehrzahl von GaN-basierenden Schichten.

Die Mehrschichtstruktur 12 weist eine erste Hauptfläche 16 und eine der ersten Hauptfläche abgewandte zweite Hauptfläche 18 auf, wobei die in der aktiven, strahlungserzeugenden Schicht 14 erzeugte Strahlung letztlich durch die zweite Hauptfläche 18 aus dem Halbleiterbauelement 10 ausgekoppelt wird. In der gezeigten Abwandlung ist die aktive Schicht 14 näher an der ersten Hauptfläche 16 als an der zweiten Hauptfläche 18 der Mehrschichtstruktur 12 positioniert. Die in Figur 1 gewählte Position ist allerdings für die nachfolgend beschriebene Strukturierung der Mehrschichtstruktur vorteilhaft, da für die Strukturierung ein dickerer Anteil der Mehrschichtstruktur 12 zur Verfügung steht.

Die Mehrschichtstruktur 12 ist über eine reflektierende Schicht 28, die vorzugsweise aus einem elektrisch leitfähigen Material besteht, auf einem Trägersubstrat 30 zum Beispiel aus Saphir, Si oder SiC aufgebracht. Die reflektierende Schicht 28 kann beispielsweise als metallische Kontaktfläche aus Ag, Al oder einer Ag- oder Al-Legierung oder alternativ als dielektrische Verspiegelung aus mehreren dielektrischen Schichten ausgebildet sein. In einer alternativen Abwandlung kann die Mehrschichtstruktur 12 auch direkt auf dem Trägersubstrat 30 aufgebracht sein, wobei in diesem Fall das Material des Trägersubstrats 30 derart ausgewählt ist, dass die Grenzfläche zwischen Mehrschichtstruktur 12 und Trägersubstrat 30 reflektierend ist.

Der Bereich der Mehrschichtstruktur 12 oberhalb der aktiven Schicht 12 lässt sich, wie deutlich in Figur 1 zu erkennen, im wesentlichen in einen planen Bereich 20, der an die aktive Schicht 14 angrenzt, und einen strukturierten Bereich 22, der an die zweite Hauptfläche 18 angrenzt unterteilen. Die Strukturierung der Mehrschichtstruktur 12 erfolgt beispielsweise mittels üblicher Lithographie- und/oder Ätzverfahren an den epitaktisch aufgewachsenen Halbleiterschichten, durch welche nutenartige Ausnehmungen bzw. Vertiefungen 24 ausgebildet werden, zwischen denen entsprechende Erhebungen 26 zurückbleiben.

Die Strukturierung der Mehrschichtstruktur 12 kann entweder eindimensional, d.h. mit Vertiefungen 24 in nur einer Koordinatenrichtung der Ebene der zweiten Hauptfläche 18, oder zweidimensional, d.h. mit Vertiefungen 24 in zwei vorzugsweise senkrecht zueinander verlaufenden Koordinatenrichtungen der Ebene der zweiten Hauptfläche 18, ausgebildet sein. Die zwischen den Vertiefungen 24 entstehenden Erhebungen 26 sind üblicherweise konvex geformt. Dabei sind eindimensionale Strukturierungen beispielsweise mit einer trapezoiden (siehe Figur 1), dreieckigen, Kreissegment- oder Halbkugel-Querschnittsform und zweidimensionale Strukturierungen entsprechend in Form von Pyramidenstümpfen, Kegelstümpfen, Kegeln, Kugelsegmenten oder Halbkugeln ausgebildet.

Die in Figur 1 dargestellten Erhebungen 26 in Form von Pyramidenstümpfen besitzen einen Öffnungswinkel α, dessen Definition entsprechend auch auf die anderen genannten Formen der Erhebungen 26 übertragbar ist. Aufgrund der konvex geformten Erhebungen 26 wird die in der aktiven Schicht 14 erzeugte Strahlung gegebenenfalls mehrfach an den Grenzflächen der Mehrschichtstruktur 12 reflektiert bis die Strahlung schließlich in dem von den Brechungsindizes der Materialien und der Umgebung abhängigen Strahlungsauskopplungskegel auf die zweite Hauptfläche 18 oder den Boden der Vertiefungen 24 trifft und somit auskoppeln kann.

Wie in den Figuren 2a) bis c) veranschaulicht, hängt der Wirkungsgrad der Strahlungsauskopplung von dem Öffnungswinkel α der Erhebungen 26 ab. Sehr steile Flanken, wie in Figur 2a) erhöhen die Oberfläche des Bauteils und sind damit für die Strahlungsauskopplung günstig, aber eine Verminderung der Anzahl aufgrund der Totalreflexion nicht auskoppelbaren Moden wird in diesem Fall nicht erzielt. Ebenfalls sollten die Flanken der Erhebungen 26 nicht zu flach gewählt sein, wie in Figur 2c) dargestellt, da in diesem Fall die Abweichung von der planparallelen Platte nur gering ist und bis zur Auskopplung eine große Anzahl von mehrfachreflexionen erfolgen muss, was aufgrund der dabei unvermeidlichen Dämpfung negativ ist.

Am günstigsten ist ein in Figur 2b) dargestellter mittlerer Winkelbereich des Öffnungswinkels α der Erhebungen 26. Bei dieser Wahl des Öffnungswinkels α kann die Strahlung, die von einer Facette der Erhebung 26 totalreflektiert wird, beim Auftreffen auf die nächste Facette der Erhebung 26 innerhalb des Strahlungsauskopplungskegels ausgekoppelt werden, wodurch auch die Anzahl der Mehrfachreflexionen in der Mehrschichtstruktur gering gehalten wird.

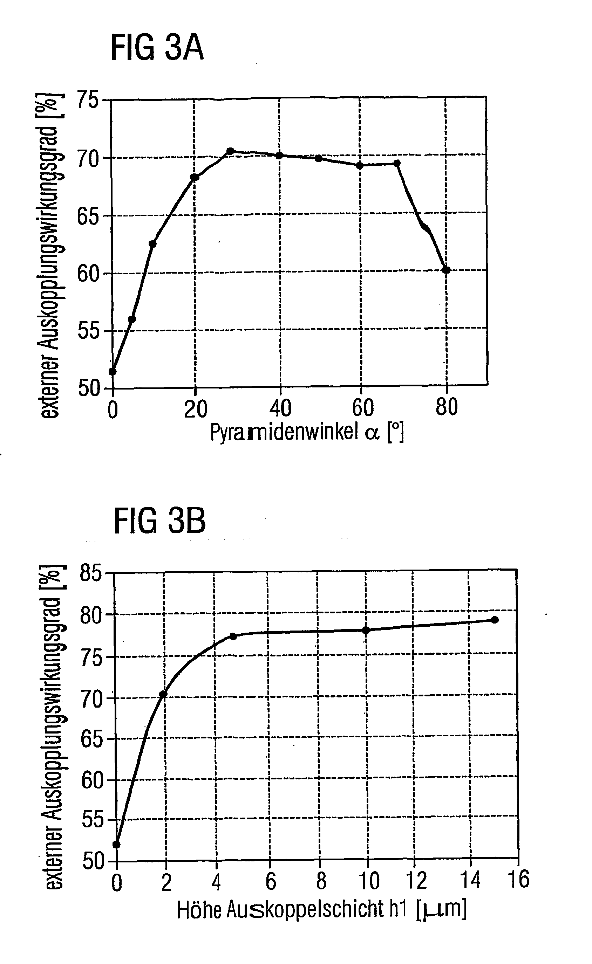

Diese Abschätzung wird auch durch eine Simulation bestätigt, deren Ergebnis in Figur 3a) gezeigt ist. Auf der Abszisse ist hierbei der Öffnungswinkel α der pyramidenstumpfförmigen Erhebungen 26 aufgetragen, und auf der Ordinate ist der externe Wirkungsgrad der Strahlungsauskopplung aufgetragen. Man erkennt deutlich, dass der beste Wirkungsgrad in einem Bereich des Öffnungswinkels α zwischen etwa 30° und etwa 70°, genauer zwischen etwa 40° und etwa 50° erreicht wird. Für Werte des Öffnungswinkels α über 70° und unter 30° fällt der Wirkungsgrad der Strahlungsauskopplung deutlich ab. Ein Öffnungswinkel α im Bereich um etwa 45° ist somit zu bevorzugen.

Ein weiterer Parameter, der den externen Wirkungsgrad der Strahlungsauskopplung beeinflusst, ist die Höhe h1 der Erhebungen 26. Zur Erzielung eines hohen Wirkungsgrades sollte die Höhe h1 der Erhebungen 26 mindestens so groß wie die Höhe h2 des an die aktive Schicht 14 angrenzenden planen Bereichs 20 gewählt werden. Bevorzugt werden die Erhebungen 26 doppelt so hoch wie der plane Bereich 20 ausgebildet; eine weitere Erhöhung der Erhebungen 26 bringt keine weitere Steigerung der Strahlungsauskopplung.

Dies wird durch eine in Figur 3b) dargestellte Simulation bestätigt. Das Simulationsergebnis zeigt für einen planen Bereich 20 mit einer Höhe h2 von etwa 2 µm den externen Wirkungsgrad der Strahlungsauskopplung über der Höhe h1 der Erhebungen 26. Bei einer Höhe h1 der Erhebungen 26 unterhalb von 2 µm, d.h. kleiner als die Höhe h2 des planen Bereichs 20, erfolgt nur eine ungenügende Strahlungsauskopplung, während bei Höhen h1 der Erhebungen 26 größer als etwa 4 µm keine wesentliche Steigerung des Wirkungsgrades mehr erkennbar ist.

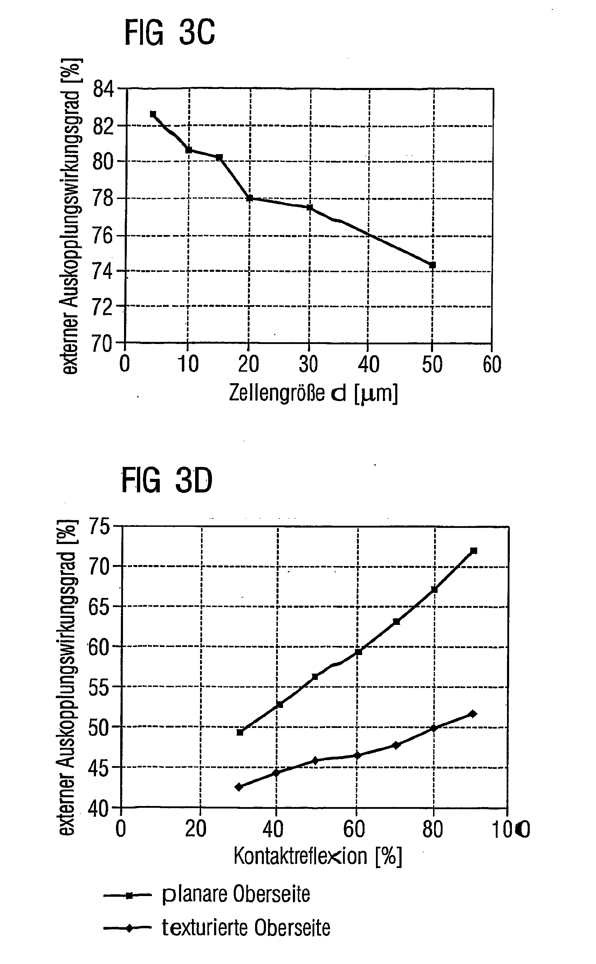

Ferner sind auch Erhebungen 26 mit relativ kleinen lateralen Abmessungen zu bevorzugen. Wie das Simulationsergebnis von Figur 3c) zeigt, ist ein Rastermaß d der Erhebungen von höchstens etwa vier- bis fünfmal der Höhe h1 der Erhebungen 26, vorzugsweise nur von etwa ein- bis dreimal der Höhe h1 der Erhebungen für einen guten Wirkungsgrad vorteilhaft.

Da das Konzept der Dünnschicht-Halbleiterbauelemente u. a. auch auf Mehrfachreflexionen beruht, hat das Reflexionsvermögen der Bauteilrückseite, d.h. der reflektierenden Schicht 28 oder der reflektierenden Grenzfläche ebenfalls einen Einfluss auf den externen Wirkungsgrad des Halbleiterbauelements. Man erkennt in dem Diagramm von Figur 3d), dass bei einem herkömmlichen planaren Dünnfilm der Wirkungsgrad der Strahlungsauskopplung nur wenig von dem Reflexionsvermögen der rückseitigen Kontaktfläche abhängt (untere Kurve in Figur 3d)). Für eine strukturierte Mehrschichtstruktur 12 wie in Figur 1 hängt der Wirkungsgrad jedoch stark von dem Reflexionsvermögen der reflektierenden Schicht 28 bzw. Grenzfläche ab (obere Kurve in Figur 3d)) und sollte möglichst über 70%, vorzugsweise über 85% gewählt werden.

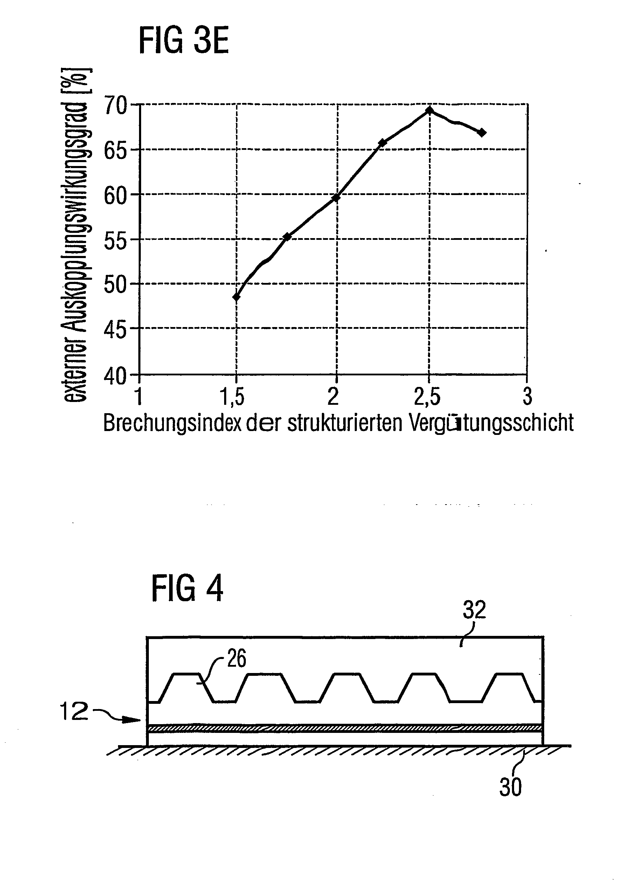

In Figur 4 ist eine Abwandlung des Halbleiterbauelements von Figur 1 dargestellt. Der Unterschied zwischen den beiden Abwandlungen besteht darin, dass auf der strukturierten zweiten Hauptfläche 18 der Mehrschichtstruktur 12 eine Schutz- bzw. Vergütungsschicht 32 vorgesehen ist. Diese Schutzschicht 32 soll einerseits den Halbleiter vor externen Einflüssen schützen, andererseits kann die Schutzschicht 32 bei geeigneter Wahl von Brechungsindex und Dicke als Entspiegelungsschicht wirken.

Als weitere Variante des Halbleiterbauelements kann auf der strukturierten zweiten Hauptfläche 18 der Mehrschichtstruktur 12 eine transparente, leitfähige Schicht mit möglichst kleinem Übergangswiderstand zum Halbleiter vorgesehen sein. Durch eine solche transparente, leitfähige Schicht kann man den Nachteil, dass die Strukturierung der Mehrschichtstruktur zur Erhöhung des Wirkungsgrades der Strahlungsauskopplung gleichzeitig eine Verringerung deren Querleitfähigkeit bewirkt, ausgleichen. Es wird eine optimale Stromzuführung zu allen Bereichen des Halbleiterbauelements erzielt, ohne durch Metallkontakte auf der Mehrschichtstruktur deren Strahlungsauskopplung zu beeinträchtigen.

Die transparente, leitfähige Schicht besteht zum Beispiel aus ZnO, SnO, InO, CdO, GaO oder einer Kombination davon. Diese Materialien zeigen eine n- oder p-Leitfähigkeit und können mittels Sputterverfahren, CVD-Verfahren oder Aufdampfen abgeschieden werden.

Ein Ausführungsbeispiel eines strahlungsemittierenden Halbleiterbauelements gemäß der Erfindung ist in Figur 5 dargestellt.

Das Dünnschicht-Halbleiterbauelement 10 weist eine Mehrschichtstruktur 12 auf GaN-Basis mit einer aktiven, strahlungserzeugenden Schicht 14 auf. Im Gegensatz zu der oben beschriebenen ersten Abwandlung ist hier aber nicht die zweite Hauptfläche 18 der Mehrschichtstruktur 12, durch welche die in der aktiven Schicht 14 erzeugte Strahlung schließlich ausgekoppelt wird, strukturiert, sondern zwischen der ersten Hauptfläche 16 und der reflektierenden Schicht oder Grenzfläche auf dem Trägersubstrat 30 ist eine transparente Schicht 34 vorgesehen, die zur Steigerung der Strahlungsauskopplung strukturiert ist. Dieser Aufbau ist insbesondere dann vorzuziehen, wenn die den Halbleiter 12 gut kontaktierenden Metalle nicht besonders hoch reflektierend sind und deshalb besser reflektierende Metalle wie Ag verwendet werden sollen, die aufgrund einer hohen Migration den Halbleiter verunreinigen können.

Zum Ausgleich einer geringeren Querleitfähigkeit des Dünnschicht-Halbleiters ist es von Vorteil, die transparente Schicht 34 aus einem leitfähigen Material auszubilden.

Die Strukturierung entspricht im wesentlichen der oben anhand der ersten Abwandlung beschriebenen. Als konvexe Erhebungen 26' kommen hier allerdings in erster Linie solche in Form von Pyramidenstümpfen oder Kegelstümpfen bzw. solche mit trapezoider Querschnittsform in Frage. Die oben anhand er Figur 3 erläuterten Parameter der Strukturierung können auf die Erhebungen 26' dieses Ausführungsbeispiels übertragen werden. Hierbei ist die plane Schicht 35 zwischen der aktiven Schicht 14 der Mehrschichtstruktur 12 und der transparenten Schicht 34 als Bezugsgröße heranzuziehen.

Eine weitere alternative Abwandlung des Halbleiterbauelements von Figur 1 ist in Figur 6 gezeigt. Bei diesem Halbleiterbauelement 10 ist nicht die Mehrschichtstruktur 12 selbst strukturiert, sondern eine auf der zweiten Hauptfläche 18 der Mehrschichtstruktur 12 aufgebrachte Vergütungsschicht 32 ist mit entsprechenden konvexen Erhebungen 36 versehen.

Typische Vergütungsschichten 32, zum Beispiel aus SiO₂ oder SiNₓ, haben einen Brechungsindex von unter 2, so dass die strahlung an der Grenzfläche zwischen Halbleiter 12 und Vergütungsschicht 32 teilweise totalreflektiert wird. Wie das Diagramm von Figur 3e) zeigt, nimmt die Effektivität der strukturierten Vergütungsschicht 32 mit zunehmender Abweichung des Brechungsindex von dem des Halbleiters mit 2,5 deutlich ab. Eine strukturierte Vergütungsschicht mit niedrigem Brechungsindex kann aber trotzdem vorteilhaft sein, da auch eine totalreflektierte Welle bis etwa zu einer Tiefe der halben Wellenlänge in das Material mit kleinerem Brechungsindex eindringt, dabei allerdings exponentiell abklingt. Die Höhe der strukturierten Vergütungsschicht sollte deshalb nicht mehr als wenige 100 nm betragen und die lateralen Abmessungen liegen im Bereich von Mikrometern.

Wenn die lateralen Abmessungen der Strukturen 36 der Vergütungsschicht 32 in den Bereich der Wellenlänge der auszukoppelnden Strahlung reduziert werden, wird eine auftreffende Welle an einer solchen Mikrostruktur 36 gestreut, wodurch der Strahl in einen größeren Winkelbereich aufgefächert wird.

Schließlich ist in Figur 7 eine weitere Abwandlung des Halbleiterbauelements von Figur 1 gezeigt. Auf der in diesem Fall nicht strukturierten Mehrschichtstruktur 12 ist eine transparente, leitfähige Schicht 38 aus zum Beispiel ZnO, SnO, InO, CdO, GaO oder einer Kombination davon aufgebracht. Diese transparente, leitfähige Schicht 38 ist analog der ersten Abwandlung von Figur 1 strukturiert, wobei in Figur 7 eine eindimensionale Strukturierung mit Erhebungen mit einer trapezoiden Querschnittsform dargestellt sind.

Der Übergangswiderstand zwischen der transparenten, leitfähigen Schicht 38 und dem Halbleiter 12 sollte möglichst gering sein. Ist dies nicht der Fall, kann zwischen der Schicht 38 und der Mehrschichtstruktur 12 eine (nicht dargestellte) Metallschicht erforderlich sein, die vorzugsweise sehr dünn und damit semitransparent oder unterbrochen ausgebildet ist.

## Patentansprüche

1. Strahlungsemittierendes Dünnschicht-Halbleiterbauelement mit einer Mehrschichtstruktur (12) auf GaN-Basis, die eine aktive, strahlungserzeugende Schicht (14) enthält und eine erste Hauptfläche (16) und eine der ersten Hauptfläche abgewandte zweite Hauptfläche (18) zum Auskoppeln der in der aktiven, strahlungserzeugenden Schicht erzeugten Strahlung aufweist, wobei
die erste Hauptfläche (16) der Mehrschichtstruktur (12) mit einer reflektierenden Schicht (28), die einen Reflexionsgrad von mindestens 85% aufweist, gekoppelt ist, und zwischen der ersten Hauptfläche (16) der Mehrschichtstruktur (12) und der reflektierenden Schicht (28) eine transparente Schicht (34) vorgesehen ist, welche ein- oder zweidimensional strukturiert ist und die sich unmittelbar an der reflektierenden Schicht (28) und an der Mehrschichtstruktur (12) befindet, und
wobei
die transparente Schicht (34) zwischen der ersten Hauptfläche (16) der Mehrschichtstruktur (12) und der reflektierenden Schicht (28) konvexe Erhebungen (26') aufweist und
die Höhe (h1) der Erhebungen (26') wenigstens so groß ist, wie die Höhe (h2) eines gesamten planen, unstrukturierten Bereichs (35) der Mehrschichtstruktur (12) zwischen der aktiven, strahlungserzeugenden Schicht (14) und der transparenten Schicht (34) mit den Erhebungen (26'), von welchem unstrukturierten Bereich (35) aus sich die Erhebungen (26') erstrecken.

2. Halbleiterbauelement nach Anspruch 1,
**dadurch gekennzeichnet, dass** die transparente Schicht (34) leitfähig ist.

3. Halbleiterbauelement nach einem der Ansprüche 1 oder 2,
**dadurch gekennzeichnet, dass** die Erhebungen (26') die Form von Pyramidenstümpfen oder Kegelstümpfen bzw. eine trapezoide Querschnittsform aufweisen.

4. Halbleiterbauelement nach einem der Ansprüche 1 bis 3,
**dadurch gekennzeichnet, dass** die Erhebungen (26') einen Öffnungswinkel (α) zwischen etwa 30° und etwa 70° aufweisen.

5. Halbleiterbauelement nach Anspruch 4,
**dadurch gekennzeichnet, dass** die Erhebungen (26') einen Öffnungswinkel (α) zwischen etwa 40° und etwa 50° aufweisen.

6. Halbleiterbauelement nach einem der Ansprüche 1 bis 5,
**dadurch gekennzeichnet, dass** die Höhe (h1) der Erhebungen (26') etwa doppelt so groß ist, wie die Höhe (h2) des unstrukturierten Bereichs (35) der Mehrschichtstruktur zwischen der aktiven, strahlungserzeugenden Schicht und den Erhebungen.

7. Halbleiterbauelement nach einem der Ansprüche 1 bis 6,
**dadurch gekennzeichnet, dass** ein Rastermaß (d) der Erhebungen (26') höchstens etwa fünfmal so groß wie die Höhe (h1) der Erhebungen ist.

8. Halbleiterbauelement nach Anspruch 7,
**dadurch gekennzeichnet, dass** das Rastermaß (d) der Erhebungen höchstens dreimal so groß wie die Höhe (h1) der Erhebungen ist.

9. Halbleiterbauelement nach einem der Ansprüche 1 bis 8,
**dadurch gekennzeichnet, dass** die reflektierende Schicht (28) auf einem Trägersubstrat (30) aufgebracht ist.

10. Halbleiterbauelement nach Anspruch 9,
**dadurch gekennzeichnet, dass** die reflektierende Schicht (28) oder das Trägersubstrat (30) zugleich als Kontaktfläche des Halbleiterbauelements dient.

11. Halbleiterbauelement nach einem der Ansprüche 1 bis 10,
**dadurch gekennzeichnet, dass** auf der zweiten Hauptfläche (18) der Mehrschichtstruktur (12) eine transparente Schutzschicht aufgebracht ist.

## Claims

1. Radiation-emitting thin-film semiconductor component with a multilayer structure (12) based on GaN, which contains an active, radiation-generating layer (14) and has a first main area (16) and a second main area (18) - remote from the first main area - for coupling out radiation generated in the active, radiation-generating layer, wherein the first main area (16) of the multilayer structure (12) is coupled to a reflective layer (28) having a reflectance of at least 85%, and a transparent layer (34) is provided between the first main area (16) of the multilayer structure (12) and the reflective layer (28), said transparent layer being patterned one- or two-dimensionally and being situated directly at the reflective layer (28) and at the multilayer structure (12), and
wherein
the transparent layer (34) between the first main area (16) of the multilayer structure (12) and the reflective layer (28) has convex elevations (26'), and
the height (h1) of the elevations (26') is at least as large as the height (h2) of an entire plane, unpatterned region (35) of the multilayer structure (12) between the active, radiation-generating layer (14) and the transparent layer (34) with the elevations (26'), from which unpatterned region (35) the elevations (26') extend.

2. Semiconductor component according to Claim 1,
**characterized in that**
the transparent layer (34) is conductive.

3. Semiconductor component as claimed in either of Claims 1 and 2,
**characterized in that**
the elevations (26') have the form of truncated pyramids or truncated cones or a trapezoidal cross-sectional form.

4. Semiconductor component according to one of Claims 1 to 3,
**characterized in that**
the elevations (26') have an aperture angle (α) of between approximately 30° and approximately 70°.

5. Semiconductor component according to Claim 4,
**characterized in that**
the elevations (26') have an aperture angle (α) of between approximately 40° and approximately 50°.

6. Semiconductor component according to one of Claims 1 to 5,
**characterized in that**
the height (h1) of the elevations (26') is approximately twice as large as the height (h2) of the unpatterned region (35) of the multilayer structure between the active, radiation-generating layer and the elevations.

7. Semiconductor component according to one of Claims 1 to 6,
**characterized in that**
a pitch (d) of the elevations (26') is at most approximately five times as large as the height (h1) of the elevations.

8. Semiconductor component according to Claim 7,
**characterized in that**
the pitch (d) of the elevations is at most three times as large as the height (h1) of the elevations.

9. Semiconductor component according to one of Claims 1 to 8,
**characterized in that**
the reflective layer (28) is applied on a carrier substrate (30).

10. Semiconductor component according to Claim 9,
**characterized in that**
the reflective layer (28) or the carrier substrate (30) simultaneously serves as a contact area of the semiconductor component.

11. Semiconductor component according to one of Claims 1 to 10,
**characterized in that**
a transparent protective layer is applied on the second main area (18) of the multilayer structure (12).

## Revendications

1. Composant semiconducteur à couche mince émettrice de rayonnement, comprenant une structure multicouche (12) à base de GaN qui contient une couche active (14) génératrice de rayonnement et présente une première surface principale (16) ainsi qu'une deuxième surface principale (18) à l'opposé de la première surface principale pour découpler le rayonnement généré dans la couche active génératrice de rayonnement,
la première surface principale (16) de la structure multicouche (12) étant couplée avec une couche réfléchissante (28), laquelle présente un degré de réflexion d'au moins 85 %, et une couche transparente (34) étant prévue entre la première surface principale (16) de la structure multicouche (12) et la couche réfléchissante (28), laquelle est structurée de manière uni- ou bidimensionnelle et se trouve directement sur la couche réfléchissante (28) et sur la structure multicouche (12), et
la couche transparente (34) présentant des élévations convexes (26') entre la première surface principale (16) de la structure multicouche (12) et la couche réfléchissante (28), et
la hauteur (h1) des élévations (26') étant au moins égale à la hauteur (h2) d'une zone entière plane, non structurée (35) de la structure multicouche (12) entre la couche active (14) génératrice de rayonnement et la couche transparente (34) avec les élévations (26'), depuis laquelle zone non structurée (35) s'étendent les élévations (26').

2. Composant semiconducteur selon la revendication 1, **caractérisé en ce que** la couche transparente (34) est conductrice.

3. Composant semiconducteur selon l'une des revendications 1 ou 2, **caractérisé en ce que** les élévations (26') présentent la forme de pyramides tronquées ou de cônes tronqués ou encore une section transversale de forme trapézoïdale.

4. Composant semiconducteur selon l'une des revendications 1 à 3, **caractérisé en ce que** les élévations (26') présentent un angle d'ouverture (α) entre environ 30° et environ 70°.

5. Composant semiconducteur selon la revendication 4, **caractérisé en ce que** les élévations (26') présentent un angle d'ouverture (α) entre environ 40° et environ 50°.

6. Composant semiconducteur selon l'une des revendications 1 à 5, **caractérisé en ce que** la hauteur (h1) des élévations (26') est environ égale au double de la hauteur (h2) de la zone non structurée (35) de la structure multicouche entre la couche active génératrice de rayonnement et les élévations.

7. Composant semiconducteur selon l'une des revendications 1 à 6, **caractérisé en ce qu'**une dimension de grille (d) des élévations (26') est au maximum environ égale à cinq fois la hauteur (h1) des élévations.

8. Composant semiconducteur selon la revendication 7, **caractérisé en ce que** la dimension de grille (d) des élévations est au maximum égale à trois fois la hauteur (h1) des élévations.

9. Composant semiconducteur selon l'une des revendications 1 à 8, **caractérisé en ce que** la couche réfléchissante (28) est appliquée sur un substrat porteur (30).

10. Composant semiconducteur selon la revendication 9, **caractérisé en ce que** la couche réfléchissante (28) ou le substrat porteur (30) sert en même temps de surface de contact du composant semiconducteur.

11. Composant semiconducteur selon l'une des revendications 1 à 10, **caractérisé en ce qu'**une couche de protection transparente est appliquée sur la deuxième surface principale (18) de la structure multicouche (12).
